# EUROPEAN PATENT SPECIFICATION

(11) **EP 2 080 221 B1**
(45) Date of publication and mention of the grant of the patent: **15.06.2011**
(21) Application number: 07868710.0
(22) Date of filing: 09.11.2007
(51) Int. Cl.: H01L 21/687

(54) **A SUSCEPTOR AND METHOD OF FORMING A LED DEVICE USING SUCH SUSCEPTOR**
SUSZEPTOR UND VERFAHREN ZUR HERSTELLUNG EINER LED-VORRICHTUNG MIT DIESEM SUSZEPTOR
SUCEPTEUR ET PROCÉDÉ DE FORMATION D'UN DISPOSITIF À DIODES ÉLECTROLUMINESCENTES METTANT EN OEUVRE UN TEL SUSCEPTEUR

(30) Priority: 10.11.2006 US 865221 P
(43) Date of publication of application: 22.07.2009
(73) Proprietor: Saint-Gobain Ceramics & Plastics, Inc., Worcester, MA 01615-0138 (US)
(72) Inventor: SIMPSON, Matthew A., Sudbury, Massachusetts 01776 (US)
(74) Representative: Zimmermann & Partner
(86) International application number: PCT/US2007/084261
(87) International publication number: WO 2008/058270

(56) References cited:
- EP-A- 1 341 216
- DE-A1- 10 329 072
- JP-A- 53 066 164
- US-A- 3 951 587

## Description

### BACKGROUND

### Field of the Disclosure

The present disclosure is related to susceptors for use in the production of electroluminescent devices, and particularly related to susceptors for use in the production of light emitting diode (LED) devices.

### Description of the Related Art

Production of LED devices continues to increase with increasing demand, partly driven by utilization of LED devices in new applications. Of these devices, blue wavelength LED devices are a recent development, utilizing doped GaN to produce desired wavelength. While single crystal GaN substrates represent an ideal template for epitaxial growth of semiconductor layers, cost and availability of such substrates has led to development of foreign substrates, such as sapphire. Beyond substrate material selection, LED manufacture typically makes use of a susceptor for receiving substrates on which LED devices are formed.

There is a need in art for methods for forming high quality LED devices, and for susceptors particularly suitable for LED device fabrication.

### SUMMARY

A susceptor for holding a single crystal wafer for LED production includes a susceptor body having a recess for receiving a single crystal wafer, wherein the recess has a surface having a surface roughness parameter Rₘₐₓ of not greater than about 10 microns. The susceptor body includes a silicon impregnated silicon carbide, and a nitride layer overlying the susceptor body.

A method of forming a semiconductor LED device includes providing a susceptor, the susceptor includes (i) a susceptor body having a recess for receiving a single crystal wafer, wherein the recess has a surface having a surface roughness Rₘₐₓ of not greater than about 10 microns, and wherein the susceptor body includes a silicon impregnated silicon carbide, and (ii) a nitride layer overlying the susceptor body. The method further calls for positioning a substrate within the recess of the susceptor body, the substrate having a growth surface, and forming a first semiconductor layer overlying the growth surface. Further, a second semiconductor layer overlying the first semiconductor layer is formed, wherein a light emitting region is formed between the first semiconductor layer and in association with the second semiconductor layer.

### BRIEF DESCRIPTION OF THE DRAWINGS

The present disclosure may be better understood, and its numerous features and advantages made apparent to those skilled in the art by referencing the accompanying drawings.
FIG. 1 is an illustration of a susceptor according to one embodiment
FIG. 2 is a cross sectional illustration of a portion of the susceptor according to one embodiment.
FIG. 3 is a flow diagram of a process for forming a LED using a particular susceptor according to one embodiment.
FIG. 4 is an illustration of a layered LED structure according to one embodiment.

The use of the same reference symbols in different drawings indicates similar or identical items.

### DESCRIPTION OF THE EMBODIMENT(S)

Numerous process challenges exist in the context of forming functional LED devices. Generally, LED fabrication process flows and equipment are desired that enable high device yield, controlled cost, and high quality devices. In connection with quality, it is generally desired to provide devices that emit light within a narrow, target radiation band. However, process conditions have been found to impact wavelength of emitted radiation, and undesirable wafer-to-wafer wavelength variations, as well as within-wafer (device-to-device) wavelength variations have been experienced.

Susceptors, utilized to support single crystal wafers during LED formation, have been studied by the present inventors. Susceptors include SiC-based components, such as monolithic CVD-SiC and graphite coated with CVD-SiC. Monolithic CVD-SiC are generally quite expensive to fabricate, and alternative solutions are sought. CVD-SiC coated graphite susceptors have been found to be quite difficult to make with tight dimensional tolerances and also have limited lives because of the development of defects, such as pinholes, caused by the degradation of the CVD-SiC coating.

According to embodiments herein, a susceptor for holding a single crystal wafer for LED production is provided that includes a susceptor body having a recess for receiving a single crystal wafer, wherein the recess has a surface having a surface roughness Rₘₐₓ of not greater than about 10 microns. The susceptor body includes a silicon impregnated silicon carbide, and a nitride layer overlying the susceptor body. For example, differences in thermal expansion and crystallographic mismatches between the substrate and the overgrown GaN layer makes epitaxial growth of crystalline layers challenging.

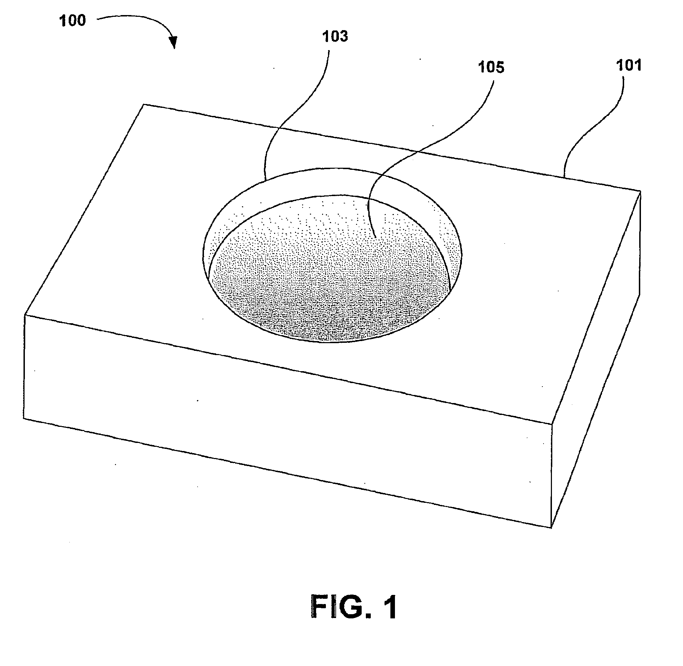

In reference to the structure of the susceptor, turning to FIG. 1, a perspective illustration of a susceptor 100 according to one embodiment is illustrated. The susceptor 100 includes a body 101 and a recess 103 for receiving a substrate. As illustrated, the recess 103 has a circular contour, and according to one embodiment, the recess has a diameter of not less than about 5.0 cm. In another embodiment, the diameter of the recess 103 is greater, such as not less than about 7.5 cm, such as not less than about 10 cm. In a particular embodiment, the circular the recess 103 can have a circular contour and a flat portion for orientation of the substrate. As will be appreciated, substrates can include flats which indicate a crystallographic orientation, and as such, the recess 103 can include a flat portion to receive and orient substrates of a particular crystallographic orientation. Additionally, the susceptor 100 can include a plurality of recesses.

The recess 103 has an average depth designed to suitably hold a substrate, and according to one embodiment the depth of the recess 103 is not greater than about 800 microns. In another embodiment, the average depth of the recess 103 is not greater than about 700 microns, or even, not greater than about 600 microns. Typically, the susceptor may have a recess depth corresponding to the thickness of the wafer expected to be processed, generally on the order of 300 to 550 microns, such as about 400 microns. The susceptor may particularly have a recess depth slightly less than the wafer thickness.

The recess has a surface 105, which is generally the bottom surface of the recess, and according to embodiments herein, the surface is smooth and facilitates uniform heating of the substrate. Accordingly, in one embodiment, the surface 105 has a surface roughness Rₘₐₓ of not greater than about 8.0 microns, such as not greater than about 5.0 microns, or even, not greater than about 2.0 microns. Still, in one particular embodiment, the surface 105 has a surface roughness Rₘₐₓ of not greater than about 1.0 micron.

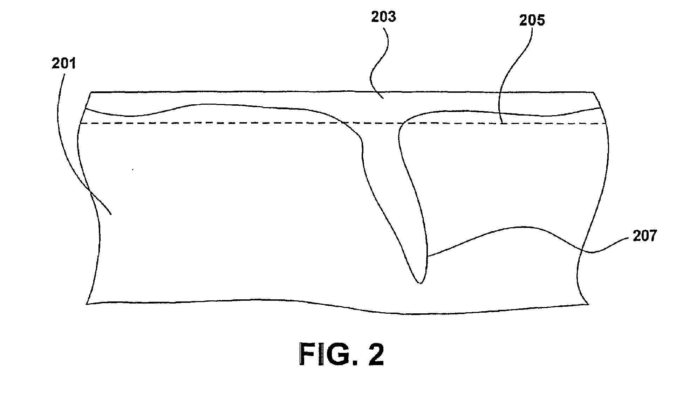

In further reference to the susceptor, referring to FIG. 2, a cross-sectional illustration of a portion of a susceptor 200 according to one embodiment is provided. As described, the susceptor includes a silicon impregnated silicon carbide material. According to one embodiment, the composition of the susceptor body 201 includes not less than about 70 wt% silicon carbide, such as not less than about 80 wt% silicon carbide, or even, not less than about 90 wt% silicon carbide. In one particular embodiment, the susceptor body 201 includes not less than about 95 wt% silicon carbide. As such, the susceptor body 201 includes an amount of impregnated silicon, particularly metal silicon impregnated into the silicon carbide during formation. According to one embodiment_{.} the susceptor body 201 generally includes an amount of silicon not greater than about 30 wt%, such as not greater than about 15 wt% silicon, or even, not greater than about 10 wt% silicon. In a particular embodiment, the susceptor body 201 includes not greater than about 5.0 wt% silicon.

Impregnating the structure with silicon provides increased density and as such, the body of the susceptor generally has a low degree of porosity, which is primarily closed porosity. Typically, the susceptor body 201 has a porosity of not greater than about 15 vol%, such as not greater than about 10 vol%, or even, not greater than about 7.5 vol%. Typically, the porosity is not greater than 5 vol%, such as not greater than 3 vol%, or even not greater than 1 vol%.

Referring again to FIG. 2, the susceptor 200 further includes a nitride layer 203 overlying the body. Generally, the nitride layer 203 is a layer of material that overlies external surfaces of the susceptor body, and particularly the nitride layer 203 can be a continuous film of material overlying otherwise exposed elemental silicon. According to one embodiment, the nitride layer 203 overlies between about 2.0% to about 20% of the external surface area of the susceptor body.

As illustrated, surface irregularities 207, such as channels or small pores filled with elemental silicon, can exist within the susceptor body 201, and according to one embodiment, the nitride layer 203 overlies those filled surface irregularities 207. More particularly, in the case of silicon infiltrated silicon carbide, typically only those portions of elemental silicon that are exposed at the external surface of the susceptor are nitrided, as discussed in more detail below. In one particular embodiment, the nitride layer 203 overlies such irregularities while maintaining a substantially smooth upper surface.

Due to surface irregularities 207 that may exist on the surface of the body, the thickness of the nitride layer 203 can be measured as an average thickness, illustrated in FIG. 2 by dashed line 205. According to one embodiment, the average thickness of the nitride layer 203 is not less than about 0.2 nm. According to another embodiment, the nitride layer 203 can have an average thickness of not less than about 0.5 nm, or not less than about 1.0 nm, such as not less than about 5.0 nm. According to a particular embodiment, the nitride layer 203 has an average thickness of within a range of between about 0.5 nm and about 2.0 nm.

Generally, the nitride layer 203 includes a ceramic or metal capable of withstanding temperatures in excess of about 1000°C. In one particular embodiment, the nitride layer 203 includes silicon, such that the majority of the nitride layer 203 includes silicon nitride. According to one embodiment, the nitride layer 203 includes not less than about 90 wt% silicon nitride, such as not less than about 95 wt% silicon nitride, or even not less than about 98 wt% silicon nitride. Still, in another embodiment, the nitride layer 203 is essentially silicon nitride.

Moreover, the nitride layer 203 is generally a dense layer of material, having a low porosity. The porosity of the nitride layer 203, which is primarily closed porosity, is generally not greater than about 5.0 vol%. According to one embodiment, the porosity of the nitride layer 203 is not greater than about 2.0 vol%, or even not greater than about 1.0 vol%.

In reference to the formation of such susceptors as provided herein, the formation of a siliconized silicon carbide body may be undertaken in accordance with procedures as disclosed in U.S. Pat. No. 3,951,587. While the susceptor shape could obviously be formed by several ceramic forming techniques, one particular method is slip casting. Susceptors of practically any length and diameter, and any degree of complexity of shape can easily and economically be performed by slip-casting. Another suitable method may include pressing, such as isostatic pressing, hot pressing, or cold pressing, or combinations thereof. Once the silicon carbide preform has been made, heat treatment is carried out to cause the silicon carbide particles to sinter with varying degrees of recrystallization taking place, depending on the time-temperature conditions employed.

The application DE 103 29 072 A1 discloses a semiconductor wafer treating element (A) comprising a surface with a silicon carbide layer (C) having a support region for supporting a wafer. The support region has protrusions (1) which contact the wafer and recesses (2) having a silicon carbide layer. A covering surface is provided between the recesses. The recesses have upper surfaces with a surface roughness (Ra) of 0.05-1.3 µm.

Another susceptor is disclosed in JP 53 066164 A. The susceptor disclosed therein comprises a carbon susceptor body, a silicon carbide layer formed on the carbon susceptor body, and coatings contg, at least silicon nitride film, selected from the group of silicon nitride film, polycrystalline silicon film and silicon oxide film, the coatings being formed on the silicon carbide layer, but no specific surface roughness is mentioned.

After the susceptor is so treated, it is then subjected to a second heat treatment to introduce the silicon into the sintered silicon carbide structure, by contacting the sintered parts with silicon at a temperature of about 2150°C in a reducing or at least a non-oxidizing atmosphere, for approximately 10 minutes. This will result in sintered shape becoming partially or wholly impregnated with silicon metal in the amount of from about 5.0 wt% to about 30 wt%, depending on the degree of density of the sintered shape. The silicon metal is generally quite pure i.e. at least 99% pure and preferably 99.9% pure silicon.

In an alternative method the sintering step as described above is eliminated and the green shaped is directly subject to the siliconizing (silicon impregnation) step, also as described above. In this manner, the silicon carbide particles are sintered and the matrix infiltrated, all in one step. Whether this approach is used, or the former, the porous silicon carbide shapes may be treated with the silicon by immersion, by placing the shapes in contact with silicon allowing capillarity and/or gravity to facilitate impregnation, or by exposing the shaped articles to silicon vapor at 2150°C.

After the silicon impregnation processing and possibly a machining step, the silicon impregnated shape is subject to a nitridation step to form the final susceptor. Such a nitridation step can include heating the susceptor in a nitrogen atmosphere such that the susceptor is exposed to the nitrogen-containing atmosphere (e.g., nitrogen or ammonia), at elevated temperatures, to effect the formation of a nitride layer by direct reaction with the elemental or free silicon, particularly to form silicon nitride. Typical nitrogen-species (e.g., nitrogen or ammonia) partial pressure is in a range of about 10²-10⁶ Pa.

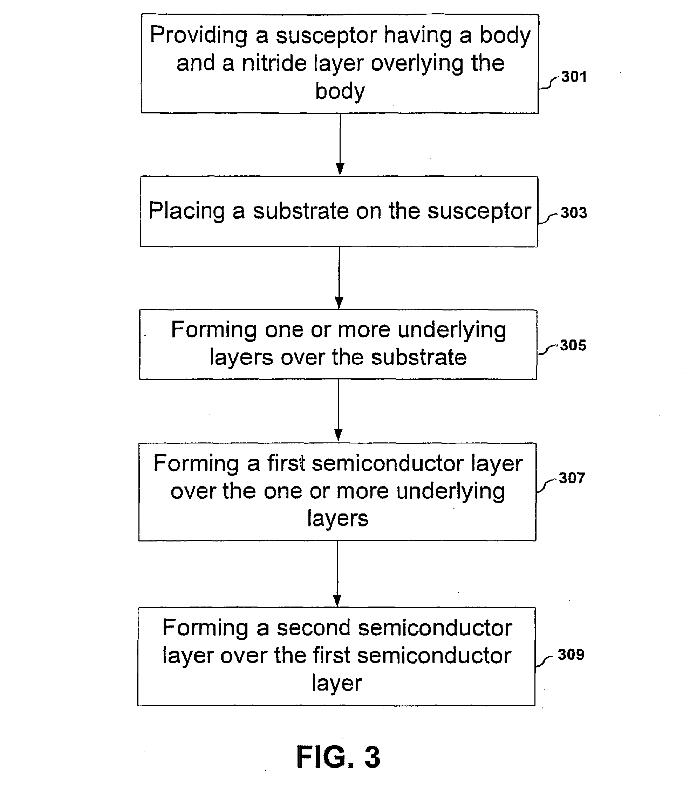

Generally, the susceptor is heated to a temperature of greater than about 500°C, and generally within a range of between about 800°C and about 1400°C. Such a temperature range facilitates formation of the nitride layer and avoids excessive temperatures which may cause mechanical strain on the susceptor. Alternatively, the processes can include utilization of physical or chemical vapor depositionn susceptors Referring to FIG. 3 a flow chart is provided that illustrates a process for forming a LED according to one embodiment. As illustrated, the first step includes providing a susceptor having a recess, as described in embodiments herein 301. Notably, the susceptor has a body including a silicon impregnated silicon carbide material and a nitride layer overlying the body. The susceptor can be provided within a growth chamber having atmospheric and temperature controls. Particularly, the susceptor is provided within a MOCVD chamber.

After providing a suitable susceptor 301, a substrate is placed on the susceptor 103. The substrate provides a crystalline growth surface for subsequent epitaxial growth of semiconductor layers facilitating the formation of a multilayered LED structure. Generally, the substrate is a single crystal wafer material, generally cut from a boule or other bulk crystalline form. The substrate materials can include elements or compositions such as, silicon carbide, silicon, sapphire, alumina, zinc or gallium nitride (GaN). In one embodiment, the substrate material is a single crystal wafer comprising essentially silicon carbide or sapphire. According to another embodiment, the substrate is a sapphire substrate having a c-plane growth surface which is placed on the susceptor such that the c-plane of the sapphire substrate is exposed for deposition.

The substrate can be placed on the surface of the susceptor. The susceptor can include a recess as described in embodiments herein, and as such, the substrate can be placed within the recess with the growth surface exposed. The recess within the susceptor facilitates precise placement of the substrate on the susceptor and accordingly within the deposition chamber. Additionally, in some applications the substrate is moved or rotated and the recess provides additional engagement of the substrate to the susceptor.

According to FIG. 3, after providing the substrate on the susceptor 303, one or more underlying layers are formed on the substrate 305. Generally, one or more underlying layers can be formed to provide a suitable growth surface template for growth of subsequent semiconductor layers. Such underlying layers can include, for example, one or more buffer layers, films, a mask or patterned layer, or non-coalescing islands or mesas of crystalline material. Particularly, in the context of semiconductor layers grown on foreign substrates, the underlying layer or layers can include a material that has a crystallographic structure that more closely matches the crystallographic structure of the overlying semiconductor layers than the crystallographic structure of the growth surface of the substrate. Suitable materials can include AIN, GaN, AIInN, GaAIN, Si, SiO₂, ZnO or a combination thereof. According one particular embodiment, the underlying layer is a buffer layer made of AIN.

The underlying layer or layers can be formed by a deposition process, such as an epitaxial growth process, optionally including photolithographic processing. According to one embodiment, the underlying layer or layers are deposited using MOCVD or also called MOVPE. Additionally, photolithographic patterning can be used to enable epitaxial lateral overgrowth (ELO) processing of the overlying semiconductor layers. The formation of the underlying layer can utilize high temperature processing, such as temperatures greater than about 800°C or even temperatures greater than 1000°C. Alternatively, in one particular embodiment, the underlying layer is a low temperature layer, such as a layer formed at a temperature of less than about 800°C, such as less than about 600°C.

In the embodiment noted above, the underlying layer is generally provided as a template for crystal growth of subsequent semiconductor layers, and is generally quite thin compared to the semiconducting layers. According to one embodiment, the underlying layer has an average thickness of less than about 400 Angstroms, such as less than about 300 Angstroms, or even less, such as less than about 200 Angstroms. According to another embodiment, the buffer layer has an average thickness within a range of between about 50 Angstroms and about 300 Angstroms.

Referring again to FIG. 3, after forming the underlying layer 305, a first semiconductor layer can be formed overlying the underlying layer 307. Generally the first semiconductor layer is one of the first layers facilitating the formation of a light emitting region. The first semiconductor layer can be formed by a deposition process, such as epitaxial growth. According to one embodiment, the first semiconductor layer is formed via a vapor deposition process such as MOCVD or MOVPE. Generally, the forming process is a high temperature process, and according to one embodiment, growth of the first semiconductor layer is conducted at temperatures not less than about 500°C, such as not less than about 700°C, or even at temperatures not less than about 900°C. Still, in one embodiment, the first semiconductor layer is formed at a temperature of not less than about 1000°C.

In further reference to the first semiconductor layer, according to another embodiment, formation of the first semiconductor layer includes formation of a semiconductor layer suitable for forming a blue LED device. As such, in one embodiment, the first semiconductor layer includes a Group III nitride composition. In one embodiment, the first semiconductor layer includes at least one element from the group of elements consisting of Ga, Al, and In. In one particular embodiment, the first semiconductor layer includes GaN.

Formation of the first semiconductor layer can include adding a dopant to the semiconductor material, such as an n-type or p-type dopant material. According to one embodiment, formation of the first semiconductor layer includes adding a n-type dopant to the material. Generally, the concentration and elements for use as a dopant depends upon the nature of the semiconductor material being doped. In one embodiment, the first semiconductor layer includes GaN and the first semiconductor layer is doped to form a n-type semiconductor layer. In a particular embodiment, the first semiconductor layer includes GaN and a n-type semiconductor layer is formed by doping a substantial portion of the GaN containing layer with a donor element such as silicon (Si). Accordingly, the donor concentration within the GaN layer may be not less than about 1.0x10¹⁷ cm-³ at 300 K, such as not less than about 1.0x10¹⁸ cm⁻³ at 300 K.

In some cases, activation of the dopants within a layer requires a deliberate processing step. As such, according to one embodiment, the method of forming the doped, first semiconductor layer also includes activating the dopant. Such a process can include a thermal annealing in a particular atmosphere at a particular temperature, or an irradiation step utilizing an electron beam, such as for example, low-energy electron beam irradiation (LEEBI) activation.

Referring again to FIG. 3, the method further includes formation of a second semiconductor layer over the first semiconductor layer 309. Like the first semiconductor layer, the second semiconductor layer makes possible the formation of the light emitting region. The second semiconductor layer can be formed by deposition, such as an epitaxial growth process, and according to one embodiment, the second semiconductor layer is formed by a vapor deposition process, such as MOCVD or MOVPE. According to another embodiment, formation of the second semiconductor layer is conducted at a temperature of not less than about 500°C, such as not less than about 700°C, or even at a temperature of not less than about 900°C. Still, in one embodiment, the second semiconductor layer is formed at a temperature of not less than about 1000°C.

In reference to the composition of the second semiconductor layer, according to another embodiment, formation of the second semiconductor layer includes formation of a semiconductor layer suitable for forming a blue LED device. As such, in one embodiment, the second semiconductor layer includes a Group III nitride composition. In one embodiment, the second semiconductor layer includes at least one element from the group of elements consisting of Ga, Al, and In. In one particular embodiment, the second semiconductor layer includes GaN.

In further reference to formation of the second semiconducting layer a dopant can be added to the second semiconductor material. In the particular embodiment described above, because the first semiconductor layer included a n-type dopant the second semiconductor layer includes a p-type dopant. According to a particular embodiment, the second semiconductor layer includes GaN, and a p-type layer is formed by doping the GaN, or at least a substantial portion of the GaN layer, with an acceptor element such as magnesium (Mg). Accordingly, the acceptor concentration within the GaN layer is generally not less than about 1.0x10¹⁸ cm⁻³ at 300 K, such as not less than about 1.0x10¹⁹ cm⁻³ at 300 K. As described in conjunction with the first semiconductor layer, a deliberate activation processing step may be required to electrically activate the acceptors doped into the second semiconductor layer. Such a process can include a thermal annealing in a particular atmosphere at a particular temperature, or an irradiation process.

In general, because silicon can be used as a dopant, particularly in the context of doping of GaN structures, it is thought that the presence of even a small amount of additional or unaccounted- for silicon within the forming chamber during formation of a layer, which functions as a dopant, can substantially change the characteristics of the device. As such, components within the growth chamber containing silicon are generally undesirable for use in such operations, particularly components containing free silicon or metal silicon.

It will be appreciated that the above described process illustrated in FIG. 3 provides a process of forming a layered LED structure according to one embodiment. Typically, one or more additional layers can be formed overlying the substrate, between the first and second semiconductor layers. According to one embodiment, at least one active layer can be formed between the first and second semiconductor layer.

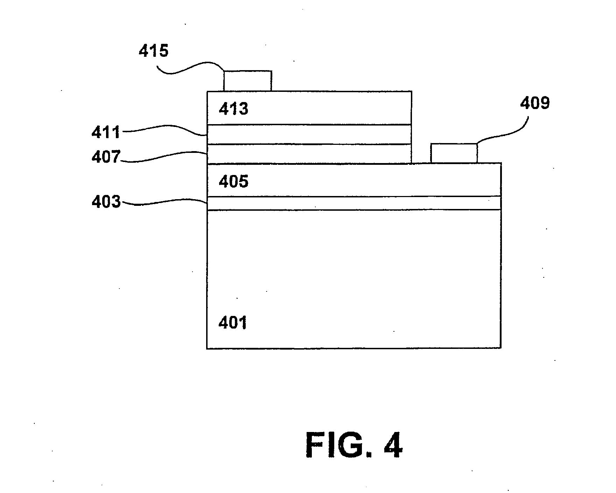

In light of the foregoing, FIG. 4 provides an illustration of a layered LED structure, according to one embodiment. Particularly, the layered LED structure is a blue LED structure that includes a series of layers among which is a substrate 401. As described above, the substrate can include a single crystal wafer material, generally cut from a boule or other bulk crystalline form, and typically made from a material such as, silicon carbide, silicon, sapphire, alumina, zinc or gallium nitride. According to a particular embodiment, the substrate material is a single crystal wafer of sapphire, such as sapphire having a c-plane growth surface.

Referring again to FIG. 4, the layered LED structure also includes layer 403, which is generally an underlying layer or buffer layer. According to one embodiment, layer 403 is a low temperature buffer layer and can be grown using MOCVD or MOVPE, at a low temperature, generally less than about 500°C. According to one embodiment, the low temperature buffer layer is thin, having a thickness of not greater than about 300 Angstroms, or even not greater than about 200 Angstroms. Moreover, the low temperature buffer layer can include elements such as Al, Ga, In, and N or a combination thereof. In a particular embodiment, the buffer layer is AIN.

Overlying layer 403 is layer 405, which according to a particular embodiment is a semiconductor layer. Particularly, in the context of a blue LED structure, layer 405 is a GaN semiconductor layer. More particularly, layer 405 is a n-type GaN semiconductor layer, which is silicon-doped. In such an embodiment, the silicon-doped GaN layer is thicker than layer 403, having a thickness greater than about 1.0 micron, typically within a range of between about 1.0 micron and about 5.0 microns.

In further reference to FIG. 4, overlying layer 405 is layer 407, which according to one embodiment, is an active layer. According to one embodiment, the active layer includes one layer of material, such as a layer forming a double heterojunction structure between layers 405 and 411. Still, in another embodiment, layer 407 includes a series of layers, which can include a single quantum well structure (SOW) or multiple quantum well (MQW) structure. According to one embodiment, the active layer can include elements, such as Ga, Al, and In or a combination thereof. Particularly suitable compositions of the active layer can include AIInGaN, AIGaN, InGaN, and GaN. In the case of the active layer comprising a plurality of layers to form a quantum well structure, the thickness of each layer can be thin, such as not greater than about 100 Angstroms, or not greater than about 50 Angstroms, and in some cases, not greater than about 25 Angstroms. (10 Angstroms = 1 nanometer)

Referring to the layered LED structure of FIG. 4, overlying layer 407 is layer 411, which according to one embodiment, is another semiconductor layer. Particularly, layer 411 can be a AIGaN semiconductor layer, and more particularly, a magnesium-doped AIGaN layer. In such an embodiment, the magnesium doped GaN layer can have a thickness of greater than about 500 Angstroms, such as greater than about 750 Angstroms, or even greater than about 1000 Angstroms.

Overlying layer 411 is layer 413, which according to one embodiment, is another semiconductor layer. Particularly, layer 413 can be a GaN semiconductor layer, and more particularly, layer 413 is a magnesium-doped GaN layer. In such an embodiment, the magnesium doped GaN layer can have a thickness of greater than about 1000 Angstroms, such as greater than about 1500 Angstroms, or even greater than about 2000 Angstroms.

FIG. 4 further illustrates contacts 409 and 415, which according to one embodiment are n-type and p-type contacts respectively. Generally, in the context of semiconductor layers comprising Group III-nitride species, such as GaN, the n-type contact includes common metals, such as Al, Ti, In, or a combination thereof. The p-type contacts typically include metals such as Ni, Au, Pd, Pt, or a combination thereof. Generally, the p-type contact is transparent or translucent, and as such, is typically a thin layer, often having a thickness of about 400 Angstroms or less.

According to embodiments described herein, susceptors and methods forming LED devices using such susceptors provide an improvement over state of the art susceptors. Manufacturing of susceptors according to embodiments herein may be carried out with high precision and tight dimensional tolerances, in a cost-effective manner. Further, such susceptors as utilized in LED processing, enable formation of high quality LED devices, at least partly due to superior composition, dimensional stability at high temperature, and dimensional precision, to control and minimize temperature variations that have a negative impact on device quality. Additionally, despite practical concerns to reduce the amount of free silicon in susceptors, embodiments herein having a silicon impregnated silicon carbide structure manage free-silicon content through use of nitridization to bind free silicon. Moreover, susceptors having the combination of features described herein according to certain embodiments also lend themselves to production of LED devices, notably improved production of blue LED devices.

While the invention has been illustrated and described in the context of specific embodiments, it is not intended to be limited to the details shown, since various modifications and substitutions can be made without departing in any way from the scope of the present invention. For example, additional or equivalent substitutes can be provided and additional or equivalent production steps can be employed. As such, further modifications and equivalents of the invention herein disclosed may occur to persons skilled in the art using no more than routine experimentation, and all such modifications and equivalents are believed to be within the scope of the invention as defined by the following claims.

## Claims

1. A susceptor for holding a single crystal wafer for LED production comprising:
a susceptor body having a recess for receiving a single crystal wafer, wherein the recess has a surface having a surface roughness Rₘₐₓ of not greater than 10 microns,
**characterised in that** the susceptor body comprises a silicon impregnated silicon carbide; and
a nitride layer overlying the susceptor body.

2. The susceptor of claim 1, wherein the surface roughness Rₘₐₓ is not greater than 2.0 microns.

3. The susceptor of any one of claims 1-2, wherein the nitride layer comprises silicon nitride,

4. The susceptor of any one of claims 1-3, wherein the nitride layer has an average thickness of not less than 0.2 nm.

5. The susceptor of any one of claims 1-4, wherein the nitride layer overlies between 2.0% and 20% of the external surface area of the body.

6. The susceptor of any one of claims 1-5. wherein the susceptor body has a porosity of not greater than 15 vol%.

7. A method of forming a semiconductor LED device comprising;
providing a susceptor comprising, (i) a susceptor body having a recess for receiving a single crystal wafer, wherein the recess has a surface having a surface roughness Rₘₐₓ of not greater than 10 microns, and wherein the susceptor body comprises a silicon impregnated silicon carbide, and (ii) a nitride layer overlying the susceptor body;
positioning a substrate within the recess of the susceptor body, the substrate having a growth surface;
forming a first semiconductor layer overlying the growth surface; and
forming a second semiconductor layer overlying the first semiconductor layer, wherein a light emitting region is formed between the first semiconductor layer and the second semiconductor layer.

8. The method of claim 7, wherein the method further comprises forming an underlying layer overlying and in contact with the growth surface of the substrate.

9. The method of claim 8, wherein the underlying layer is a buffer layer.

10. The method of claim 9, wherein the buffer layer comprises an element selected from the group consisting of gallium, indium and aluminum.

11. The method of any one of claims 7-10, wherein forming a first semiconductor layer is carried out by epitaxial growth of a semiconductor material.

12. The method of claim 11, wherein the first semiconductor layer comprises a Group III-V nitride semiconductor material.

13. The method of claim 11, wherein forming the first semiconductor layer includes doping the semiconductor material to form an n-type semiconductor material.

14. The method of any one of claims 7-13, wherein forming the second semiconductor layer is carried out by epitaxial growth of a semiconductor material.

15. A method of forming a susceptor, comprising:
providing a porous preform comprising silicon carbide;
impregnating the porous preform with elemental silicon to form a susceptor body;
farming a nitride layer to overlie the susceptor body, wherein the susceptor body has a recess for receiving a single crystal wafer, wherein the recess has a surface having a surface roughness Rₘₐₓ of not greater than 10 microns.

## Patentansprüche

1. Suszeptor zum Halten eines einkristallinen Wafers für eine LED-Produktion, umfassend:
einen Suszeptorkörper mit einer Ausnehmung zum Aufnehmen eines einkristallinen Wafers, wobei die Ausnehmung eine Oberfläche mit einer Oberflächenrauheit Rₘₐₓ von höchstens 10 Mikrometer aufweist,
**dadurch gekennzeichnet, dass** der Suszeptorkörper ein siliziumimprägniertes Siliziumcarbid umfasst und
eine Nitridschicht über dem Suszeptorkörper liegt.

2. Suszeptor nach Anspruch 1, wobei die Oberflächenrauheit Rₘₐₓ höchstens 2,0 Mikrometer beträgt.

3. Suszeptor nach einem der Ansprüche 1-2, wobei die Nitridschicht Siliziumnitrid umfasst.

4. Suszeptor nach einem der Ansprüche 1-3, wobei die Nitridschicht eine mittlere Dicke von mindestens 0,2 Nanometer aufweist.

5. Suszeptor nach einem der Ansprüche 1-4, wobei die Nitridschicht über zwischen 2,0% und 20% der externen Oberfläche des Körpers liegt.

6. Suszeptor nach einem der Ansprüche 1-5, wobei der Suszeptorkörper eine Porosität von höchstens 15 Vol-% aufweist.

7. Verfahren zum Ausbilden eines Halbleiter-LED-Bauelements, umfassend:
Bereitstellen eines Suszeptors, umfassend (i) einen Suszeptorkörper mit einer Ausnehmung zum Aufnehmen eines einkristallinen Wafers, wobei die Ausnehmung eine Oberfläche mit einer Oberflächenrauheit Rₘₐₓ von höchstens 10 Mikrometer aufweist, und wobei der Suszeptorkörper ein siliziumimprägniertes Siliziumcarbid umfasst, und (ii) eine Nitridschicht, die über dem Suszeptorkörper liegt;
Positionieren eines Substrats innerhalb der Ausnehmung des Suszeptorkörpers, wobei das Substrat eine Wachstumsoberfläche aufweist;
Ausbilden einer ersten Halbleiterschicht, die über der Aufwachsoberfläche liegt; und
Ausbilden einer zweiten Halbleiterschicht, die über der ersten Halbleiterschicht liegt, wobei ein lichtemittierendes Gebiet zwischen der ersten Halbleiterschicht und der zweiten Halbleiterschicht ausgebildet wird.

8. Verfahren nach Anspruch 7, wobei das Verfahren weiterhin das Ausbilden einer darunterliegenden Schicht umfasst, die über der Aufwachsoberfläche des Substrats liegt und mit dieser in Kontakt steht.

9. Verfahren nach Anspruch 8, wobei die darunterliegende Schicht eine Pufferschicht ist.

10. Verfahren nach Anspruch 9, wobei die Pufferschicht ein Element umfasst, ausgewählt aus der Gruppe bestehend aus Gallium, Indium und Aluminium.

11. Verfahren nach einem der Ansprüche 7-10, wobei das Ausbilden einer ersten Halbleiterschicht durch epitaxiales Aufwachsen eines Halbleitermaterials ausgeführt wird.

12. Verfahren nach Anspruch 11, wobei die erste Halbleiterschicht ein Gruppe-III-V-Nitridhalbleitermaterial umfasst.

13. Verfahren nach Anspruch 11, wobei das Ausbilden der ersten Halbleiterschicht das Dotieren des Halbleitermaterials zum Ausbilden eines Halbleitermaterials vom n-Typ beinhaltet.

14. Verfahren nach einem der Ansprüche 7-13, wobei das Ausbilden der zweiten Halbleiterschicht durch epitaxiales Aufwachsen eines Halbleitermaterials ausgeführt wird.

15. Verfahren zum Ausbilden eines Suszeptors, umfassend:
Bereitstellen einer porösen Vorform, umfassend Siliziumcarbid;
Imprägnieren der porösen Vorform mit elementarem Silizium, um einen Suszeptorkörper auszubilden;
Ausbilden einer Nitridschicht, die über dem Suszeptorkörper liegt, wobei der Suszeptorkörper eine Ausnehmung zum Aufnehmen eines einkristallinen Wafers aufweist, wobei die Ausnehmung eine Oberfläche mit einer Oberflächenrauheit Rₘₐₓ von höchstens 10 Mikrometer aufweist.

## Revendications

1. Suscepteur pour maintenir une plaquette monocristalline pour la production de diodes électroluminescentes (DEL) comprenant:
un corps de suscepteur comportant une encoche pour recevoir une plaquette monocristalline, l'encoche ayant une surface présentant une rugosité de surface Rₘₐₓ inférieure ou égale à 10 µm, **caractérisé en ce que** le corps de suscepteur comprend un carbure de silicium imprégné de silicium ; et
une couche de nitrure recouvrant le corps de suscepteur.

2. Suscepteur selon la revendication 1, dans lequel la rugosité de surface Rₘₐₓ est inférieure ou égale à 2,0 µm.

3. Suscepteur selon l'une quelconque des revendications 1 et 2, dans lequel la couche de nitrure comprend du nitrure de silicium.

4. Suscepteur selon l'une quelconque des revendications 1 à 3, dans lequel la couche de nitrure a une épaisseur moyenne supérieure ou égale à 0,2 nm.

5. Suscepteur selon l'une quelconque des revendications 1 à 4, dans lequel la couche de nitrure recouvre entre 2,0 % et 20 % de la surface externe du corps.

6. Suscepteur selon l'une quelconque des revendications 1 à 5, dans lequel le corps de suscepteur a une porosité inférieure ou égale à 15 % en volume.

7. Procédé de formation d'un dispositif semi-conducteur à DEL comprenant:
l'obtention d'un suscepteur comprenant (i) un corps de suscepteur comportant une encoche pour recevoir une plaquette monocristalline, l'encoche ayant une surface présentant une rugosité de surface Rₘₐₓ inférieure ou égale à 10 µm, et le corps de suscepteur comprenant un carbure de silicium imprégné de silicium, et (ii) une couche de nitrure recouvrant le corps de suscepteur;
le positionnement d'un substrat à l'intérieur de l'encoche du corps de suscepteur, le substrat comportant une surface de croissance;
la formation d'une première couche semi-conductrice recouvrant la surface de croissance; et
la formation d'une deuxième couche semi-conductrice recouvrant la première couche semi-conductrice, une région émettant de la lumière étant formée entre la première couche semi-conductrice et la deuxième couche semi-conductrice.

8. Procédé selon la revendication 7, le procédé comprenant en outre la formation d'une couche sous-jacente recouvrant et en contact avec la surface de croissance du substrat.

9. Procédé selon la revendication 8, dans lequel la couche sous-jacente est une couche tampon.

10. Procédé selon la revendication 9, dans lequel la couche tampon comprend un élément choisi dans le groupe constitué par le gallium, l'indium et l'aluminium.

11. Procédé selon l'une quelconque des revendications 7 à 10, dans lequel la formation d'une première couche semi-conductrice est réalisée par croissance épitaxiale d'un matériau semi-conducteur.

12. Procédé selon la revendication 11, dans lequel la première couche semi-conductrice comprend un matériau semi-conducteur en nitrure des groupes III-V.

13. Procédé selon la revendication 11, dans lequel la formation de la première couche semi-conductrice comprend le dopage du matériau semi-conducteur pour former un matériau semi-conducteur de type n.

14. Procédé selon l'une quelconque des revendications 7 à 13, dans lequel la formation de la deuxième couche semi-conductrice est réalisée par croissance épitaxiale d'un matériau semi-conducteur.

15. Procédé de formation d'un suscepteur, comprenant:
l'obtention d'une préforme poreuse comprenant du carbure de silicium;
l'imprégnation de la préforme poreuse avec du silicium élémentaire pour former un corps de suscepteur; et
la formation d'une couche de nitrure pour recouvrir le corps de suscepteur, le corps de suscepteur comportant une encoche pour recevoir une plaquette monocristalline, l'encoche ayant une surface présentant une rugosité de surface Rₘₐₓ inférieure ou égale à 10 µm.
